# EUROPEAN PATENT SPECIFICATION

(11) **EP 3 520 146 B1**
(45) Date of publication and mention of the grant of the patent: **19.01.2022**
(21) Application number: 17781039.7
(22) Date of filing: 27.09.2017
(51) Int. Cl.: H01L 31/0368, H01L 31/065, H01L 31/20, H01L 31/075, H01L 21/02, C23C 16/44, C23C 16/24, C23C 16/02, C23C 16/32, C23C 16/40

(54) **SOLAR CELL APPARATUS AND METHOD FOR FORMING THE SAME**
SOLARZELLENVORRICHTUNG UND VERFAHREN ZUR FORMUNG DAVON
APPAREIL À CELLULE SOLAIRE ET SON PROCÉDÉ DE FORMATION

(30) Priority: 27.09.2016 IT 201600096823
(43) Date of publication of application: 07.08.2019
(73) Proprietor: Enel Green Power Italia S.r.l., 00198 Rome (IT)
(72) Inventor: GERARDI, Cosimo, 95040 Catania (IT); BATTAGLIA, Anna, 95021 Catania (IT)
(74) Representative: Locas, Davide
(86) International application number: PCT/EP2017/074541
(87) International publication number: WO 2018/060278

(56) References cited:
- WO-A1-2010/022527
- WO-A2-2011/033072
- JP-A- S 632 385
- US-A1- 2010 307 574
- US-A1- 2011 146 773
- US-A1- 2012 211 069
- US-A1- 2013 048 987

## Description

### Field of the invention

The present invention relates to a solar cell apparatus of the type comprising a p-i-n structure and a method for forming the same.

### Background of the invention

Solar cell apparatuses are largely diffused and world widely utilized as electrical devices capable of converting the energy of light directly into electricity by the photovoltaic effect. P-i-n structures based on doped silicon semiconductors and transparent conductive oxides (TCO) are typical and fundamental components of these devices comprising a p-type silicon based semiconductor region (e.g. p-type layer), a n-type silicon based semiconductor region (e.g. n-type layer) and a lightly doped "near" intrinsic silicon based semiconductor region (e.g. i-type layer). TCO is extremely important as front contact for thin film solar cells and its optical and electrical properties determine the correct behaviour of the device. Typically, high transmittance, low resistivity and high haze (diffused to total transmittance ratio) are characteristics pursued to improve the performances of the solar cell apparatuses. Furthermore, the efficiency of silicon based solar cells is strongly sensitive to the transparent conducting oxide TCO used as transparent front contact: p-i-n solar cells are typically designed in a certain configuration where the p-type silicon is in direct electric contact with the front TCO. It is known that p-i-n cells use a textured TCO (e.g. tin dioxide (SnO₂)) front contact that has suitable transmittance and electrical properties even though susceptible to reduction by hydrogen during the Plasma Enhanced Chemical Vapour Deposition (PECVD). On the contrary, other TCOs such as zinc oxide (ZnO) are interesting alternative to SnO₂ being more resistant to hydrogen plasma induced damaging and with higher transmission values as well. Most common ZnO films are generally obtained either by Physical Vapour Deposition (PVD) or by Chemical Vapour Deposition (CVD): these are cost-effective techniques if compared to the high temperature range (550°C-650°C) used for the deposition of SnO₂ by atmospheric pressure CVD. When produced by PVD-sputtering deposition the ZnO layer is flat, due to the deposition growth directions induced by the magnetic field during formation process, and in order to achieve a suitable and advantageous texture a further post deposition chemical attach, typically by HCl, is required. In the latter case of a Metal organic (MO) CVD deposition, the obtained film is naturally textured and by tuning the deposition conditions it is possible to control the optical haze properties obtaining high values.

An example of a p-i-n type solar cells with ZnO as TCO is disclosed in US 2013/0048987, relating to a method for forming a p-i-n structure on a substrate including forming a bi-layer p-type layer on the substrate by: depositing a microcrystalline p-type layer over the protective layer; and depositing an amorphous p-type layer over the microcrystalline p-type layer; depositing an amorphous i-type layer via hot wire chemical vapour deposition over the amorphous p-type layer; and depositing an amorphous n-type layer over the amorphous i-type layer. According to one of the embodiment of US 2013/0048987 the p-i-n structure includes a bi-layer p-type layer disposed above a substrate, the bi-layer p-type layer having a microcrystalline p-type layer and an amorphous p-type layer disposed over the microcrystalline p-type layer; an amorphous i-type layer disposed over the bi-layer p-type layer; and an n-type layer disposed over the i-type layer.

Other examples of a p-i-n type solar cell with ZnO as a transparent conductive oxide layer are disclosed in WO 2011/033072 A2 and US 2010/307574 A1.

As a general benefit the higher haze properties and good transmittance of ZnO allow the solar cell to capture more light inside its absorber layers. Despite the higher photocurrent generation, related to more trapped light in the silicon layers, the fabrication of p-i-n type solar cells with ZnO as TCO results in a lower fill factor (FF) and significantly lower open circuit voltage (Voc). This drawback essentially rises from the presence of a rectifying contact between the p-type silicon material (of the p-i-n structure) and the n-type ZnO layer, due to the ZnO work-function significantly lower than that of p-type silicon based material. It is then apparent that, in order to take advantage of the higher light trapping properties of the as-grown textured ZnO with respect to SnO₂, it is necessary to reduce the depletion layer at the interface between ZnO and the p-type silicon based layer and smooth, throughout designed interfacial layers, the work function mismatching lessening the contact resistance together with increasing the open circuit voltage (Voc) as a benefit of a better junction built-in potential (Vbi).

### Summary of the invention

The aim of the invention is to provide a solar cell apparatus and a method for forming the same that overcomes the drawbacks of known solar cell apparatuses. Within this aim, a further object of the invention is providing a solar cell apparatus in which the n-doped TCO/p-Si work function mismatch is reduced, significantly improving the solar cell performances.

Another object of the invention is to overcome the problem of low work function TCOs, including the fabrication of p-type transparent conducting oxide layers.

A further object of the invention is to provide a solar cell apparatus in which it is possible to fully take advantage of the better optical properties of TCO materials like the ZnO, without reducing the carrier conduction at the interface.

Still another object of the invention is to provide a method for forming a solar cell apparatus which is suitable for large area photovoltaic modules applications.

These and other aims are achieved by the present invention by a solar cell apparatus according to claim 1 and by a method for forming a solar cell apparatus according to claim 5.

Preferred features of the invention are defined in the dependent claims.

It is to be understood that according to the present invention it is possible to obtain a lower work-function TCO, with better optical transmittance and controllable haze. Accordingly it is possible to obtain improved performances, in particular in term of Voc.

Furthermore, the solar cell apparatus of the present invention provides a reduced work function mismatch and reduction of the depletion layer of at the ZnO/p-SiC interface.

### Brief description of the drawings

These and other features and advantages of the invention will be better apparent from the following description of some exemplary and non-limitative embodiments, to be read with reference to the attached drawings, wherein:
- Fig. 1 is an illustrative and partial cross-sectional view of a solar cell apparatus in accordance with some embodiments of the present invention;
- Fig. 2 is a sectional view comprising, on enlarged scale, the detailed sequence of the p-type dopants graded multi-layers structure;
- Fig. 3 is a flow diagram of a method of formation of a solar cell apparatus via PECVD in accordance with some embodiments of the present invention;
- Fig. 4 is a schematic view of a PECVD equipment;
- Fig. 5 is a graph showing a silane and dopant concentration ratio during the growth of the nano-crystalline layer at the interface with the TCO layer;
- Fig. 6 is a graph showing a comparison of illuminated I-V curves in a module according to the present invention and in a module of the prior art; and
- Fig. 7 is a graph showing a comparison of illuminated J-V curves obtained for a small area tandem solar cell according to the present invention and for solar cells according to the prior art;
- Fig. 8 is an X-Ray Diffraction (XRD) spectrum of a Low Pressure Chemical Vapour Deposition (LPCVD) ZnO:B layer designed for a a-Si:H cell;
- Fig. 9 is a schematic drawing of the hexagonal wurzite structure of ZnO.

### Detailed description of the invention

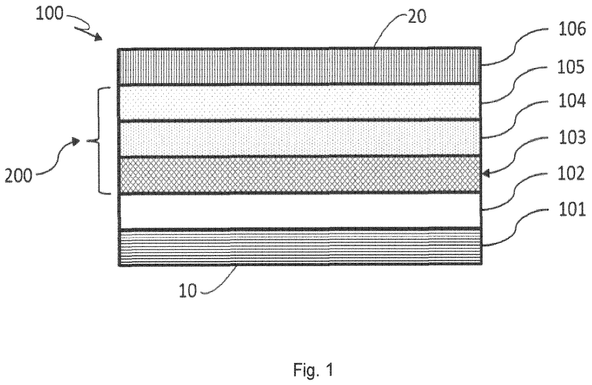

With reference initially to Fig. 1, a solar cell apparatus according to the present invention is globally represented with the reference number 100. According to the present invention, the solar cell apparatus 100 comprises a substrate 101, preferably produced with ceramic or metallic or polymeric or composite materials or the like.

Preferably, the substrate 101 identifies a first end 10 of the solar cell apparatus 100 over which further layers are realized.

As will be better described in the following, in an embodiment, the substrate 101 can be deposited via Chemical Vapour Deposition (CVD) methods.

According to the present invention, the solar cell apparatus comprises an n-type transparent conductive oxide (TCO) layer 102 and a p-i-n structure 200.

The p-i-n structure 200 comprises a p-type layer 103, an i-type layer 104, an n-type layer 105. According to a preferred embodiment, a metal back layer 106 is arranged on the p-i-n structure 200 and defines a second end 20 of the solar cell apparatus 100 opposite to the first end 10.

According to a preferred embodiment, the n-type transparent conductive oxide (TCO) layer 102, the p-i-n structure 200 and the metal back layer 106 are sequentially deposited over the substrate 101.

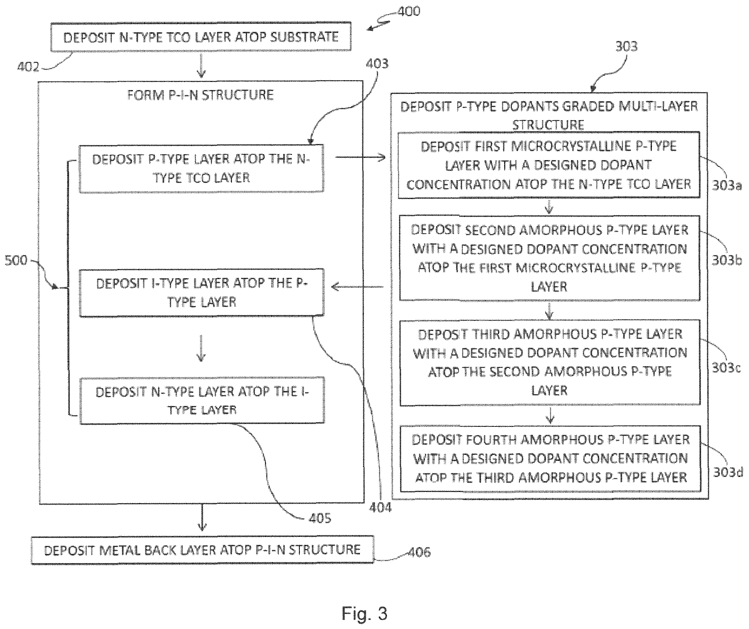

As schematically represented in Fig. 3, the above layers are preferably deposited via PECVD in accordance with some embodiments of the present invention, by means of a method globally represented with the reference number 400.

According to a preferred embodiment, the method 400 is performed on the substrate 101 over which further layers or regions of materials are deposited.

Preferably, the substrate 101 is made of any suitable material to support and enhance a p-i-n junction and therefore to positively collaborate in generating the solar cell apparatus 100. The method 400 generally begins at 402 wherein the n-type transparent conductive oxide (TCO) layer 102 is deposited over the substrate 101, preferably via Plasma Enhanced Chemical Vapour deposition (PECVD).

According to an example which is not a part of the present invention, the n-type transparent conductive oxide (TCO) layer 102 comprises any material suitable to provide electrical conductivity together with sufficient transparency for the equipment. As an example, in some embodiments, the n-type transparent conductive oxide (TCO) layer 102 comprises cadmium stannate (Cd₂SnO₄), tin oxide (SnO), tin dioxide (SnO₂), combination thereof such as indium-tin oxide (ITO) or the like. According to the present invention the n-type transparent conductive oxide (TCO) is zinc oxide (ZnO).

The n-type transparent conductive oxide (TCO) layer 102 comprises, in some embodiments, further dopants such as boron (B) gallium (Ga), aluminum (Al), tin (Sn).

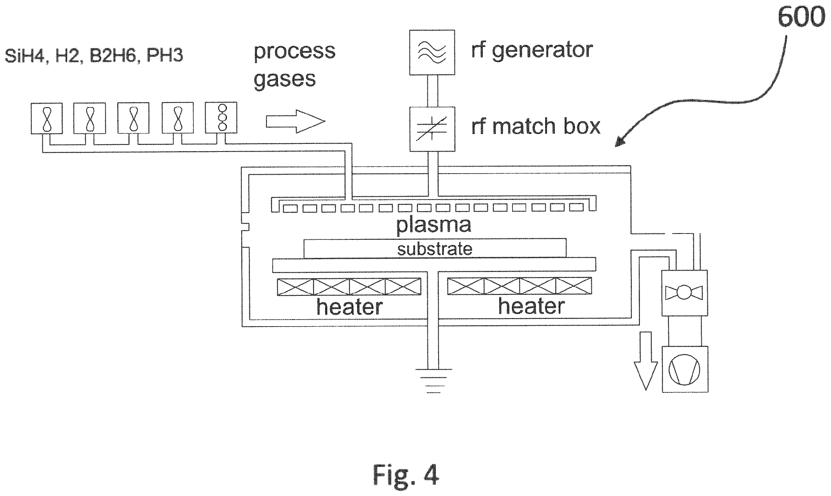

With reference to Fig. 4, according to a preferred embodiment, the deposition is obtained by a PECVD equipment 600.

The PECVD process offers the intrinsic benefit to have the possibility to produce at the previous phase 402 of the method 400 an as-grown textured n-type transparent conductive oxide (TCO) layer 102, improving light absorption by enhancing light trapping within it. According to a preferred embodiment, by tuning the deposition conditions of the method 400 achieved by using the PECVD equipment 600, and depositing ZnO as the n-type transparent conductive oxide (TCO) layer 102 it is possible to control the optical haze properties (where haze is the ratio between diffused and total transmittance through the TCO) up to values higher than 40% at a wavelength of 550nm with respect to the prior art.

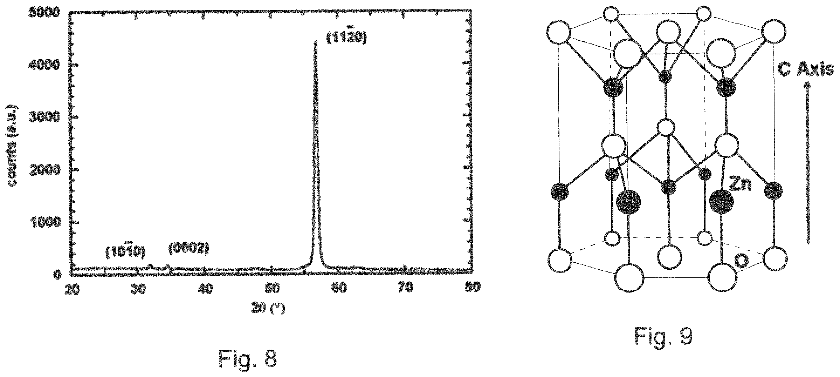

It is therefore clear that higher haze properties together with good transmittance allow the solar cell apparatus 100 to capture more light inside its absorbing layers and thus to improve its efficiency. Typical crystallographic structure of ZnO:B TCO's for a-Si cells application. X-ray diffraction spectrum shows a strong preferential crystallographic orientation, within the (112̅0) plane parallel to the surface. The peaks positions observed for Low Pressure Chemical Vapour Deposition (LPCVD) ZnO:B concur with the literature for ZnO layers that crystallize in the hexagonal wurtzite (B4 type) structure and fit in the space group. The preferential crystallographic growth axis is within the plane (112̅0), parallel to the substrate. This preferential orientation is typical for ZnO film growth by LPCVD [Wenas 1991, Faÿ 2005] in the range of temperatures (i.e. 150 °C -200 °C) that produce films with a rough surface, suitable for thin film solar cells applications. A representation of the position of the atoms in the elementary cell for the hexagonal wurtzite structure of ZnO requires the following lattice parameters a = 3.25 Å and c = 5.602 Å [Reeber 1970]. The structure is composed of two interpenetrating hexagonal close packed sub-lattices; zinc atoms are surrounded by four oxygen atoms that form a tetrahedral pyramid, and vice versa. This tetrahedral coordination corresponds to a sp3 covalent bond, but this material also has a strong ionic character [Jagadish 2006]. Due to the non-symmetry of the [0002] and [0002] directions, this structure shows two possible polarities along the c axis (see fig. 8 and 9).

A further benefit rising from depositing ZnO as TCO on the substrate 101 is that this ceramic material resists better than SnO₂ to hydrogen plasma induced damages on the surfaces maintaining high transmission features (typical optical and electrical parameters are compared in Table I listed below).

**Table I: Optical and electrical properties comparison table. SnO2:F vs ZnO:B TCO's are compare.**

| | TCO Thickness (nm) | Total Transmittance (avg 400-100 nm) | Haze (@550 nm) | Sheet Resistance (ohm/sq) | Mobility | Carrier Concentrati on (cm-3) |
|---|---|---|---|---|---|---|
| SnO2:F Off line TCO | 700 | 84 | 10% | 8,3 | 25 | 3,00E+20 |
| MOCVD ZnO:B | 1700 | 86 | 15% | 15 | 32 | 1,00E+20 |

With reference again to Figs. 1-3, the p-i-n structure 200 comprising the p-type layer 103, the i-type layer 104 and the n-type layer 105 is deposited at 500 of the method 400 on the n-type transparent conductive oxide (TCO) layer 102 preferably via PECVD.

The p-type layer 103 is produced accordingly in step 403 of the method 400. Preferably, to improve the photons absorption of the i-type layer 104, the p-type layer 103 is produced with either SiC or SiOx or SixNy or a combination thereof.

In an embodiment, Si, SiC or SiOx are amorphous hydrogenated layers. It should be noted that SiC, SiOx or SixNy are advantageously used because of their higher energy gaps that ensure high transmittance of photons with energy close to the a-Si:H energy gap.

It will be also apparent that despite the higher photocurrent generation, related to more trapped light in the silicon layers, the fabrication of the p-i-n structure 200 with single (a-Si:H) or double junctions (a-Si:H/µc-Si:H) solar cell apparatus 100 on ZnO as the n-type transparent conductive oxide (TCO) layer 102 results in a lower fill factor (FF) and significantly lower open circuit voltage (Voc). Essentially, a rectifying contact is formed between the p-type layer 103 and the ZnO n-type transparent conductive oxide (TCO) layer 102 because ZnO work-function is significantly lower than that of the p-type layer 103: ZnO work function is of about 4.65eV whereas that of amorphous Si, generally comprised in the p-type layer 103, is 4.9eV or even higher. Differently, the work function of SnO₂ TCO is of about 4.9eV, i.e. well aligned with the p-type layer 103 silicon based semiconductor (or SiC or SiOx or SixNy based). It is evident that in order to take advantage of the higher light trapping properties of textured ZnO with respect to SnO₂ it is necessary to reduce the depletion layer at the interface between the n-type transparent conductive oxide (TCO) layer 102 when ZnO based and the p-type layer 103. The p-type layer comprises amorphous, nanocrystalline or microcrystalline structures or combination thereof with the possibility of manifesting different levels of dopants concentrations within to enhance charge collection.

It is important to note that the combination of multi-layers of a-Si and µc-Si is presented in combination with the doping modifications. The nanocrystalline silicon layer as interface layer has a significantly lower resistivity than p-type amorphous silicon based layer (a-Si:H, a-SiC:H, a-SixNy:H or a-SiOx:H) and very good optical properties.

The thin interfacial layer is deposited between the n-type TCO film and the p-type a-SiC:H layer (or a-SiN:H or a-SiOx:H) and tuning the thicknesses and the gas ratios with multideposition steps to obtain a right trade-off between increased light absorption, which leads to a higher short circuit current (Isc), and improved FF and Voc, thanks to the reduced band-offset and better work-function matching,

Series resistance can be reduced because of the higher conductivity moreover, it can partially replace highly defective p-type silicon carbide layer as cell window layer. A thin p-SiC:H layer is needed to avoid the formation of a crystalline silicon layer prior the intrinsic a-Si deposition, which can lower the open circuit voltage of the solar cell. In some new evolutions SiOx or SixNy are used in place of SiC as high energy gap (Eg) window layers.

During the interface Si thin layer deposition the Silane concentration (SiH4/(H2+SiH4) ) ratio is properly chosen to minimize the incubation time due to H2 induced ZnO surface modification, thus avoiding the formation of low density nucleation micro or nano-crystallites and to have fully coalesced micro-or nano crystalline phase and not amorphous or mixed phases. Deposition rate of the interface layer plays also an important role. In fact, a too slow growth could fail to protect the TCO from H2 induced accumulation layer which increases the depletion zone. This is controlled and regulated by SiH4 flow and RF power.

According to a preferred embodiment, dopants comprised in the p-type layer 103 are, for example, elements of the Group III such as boron (B), aluminum (Al), gallium (Ga) and combination thereof. Further preferably, precursors gas containing B are used due to their characteristic of being easier and safer to be used and handle than Al or Ga ones during plasma deposition processes.

To reduce the high contact resistance between the n-type transparent conductive oxide (TCO) layer 102 (preferably ZnO based) and the p-type layer 103 to increase the Voc due to the increased junction built-in (V_{bi}) potential a thin and highly doped p-type layer comprising a nanocrystalline phase is produced allowing to reduce the n-type transparent conductive oxide (TCO) layer 102 (preferably ZnO based)/ p-type layer 103 Si based work function mismatch, significantly improving the solar cell apparatus 100 performances.

Actually, in this way it is possible to fully take advantage of the better optical properties of TCO materials like ZnO, without reducing the carrier conduction at the interface with the p-type layer 103.

In the solar cell apparatus of the present invention, the p-type layer 103 comprises a p-type dopants graded multi-layers structure 3 having a dopants concentration profile that varies as a function of thickness of said structure 3, thus allowing to gain smooth potential drops as a function of varying thickness.

To this end, at 303 of the method 400 the p-type dopants graded multi-layers structure 3, comprised in the p-type layer 103, is produced over the n-type transparent conductive oxide (TCO) layer 102.

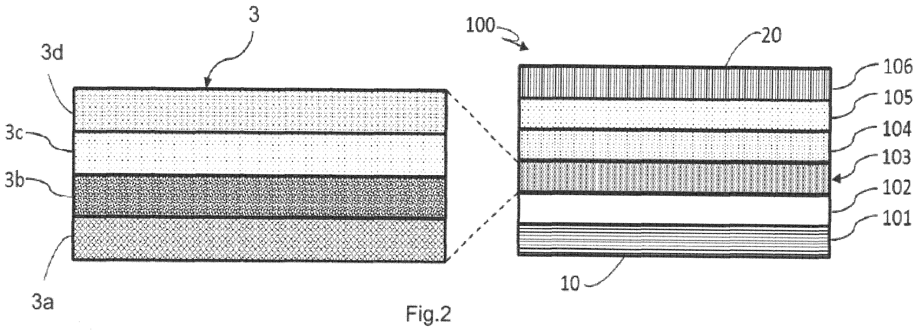

Fig. 2 is a sectional view comprising, at an enlarged scale, the detailed sequence of the p-type dopants graded multi-layers structure 3.

According to the present invention, in 303a a first nanocrystalline or microcrystalline p-type layer 3a is deposited over the n-type transparent conductive oxide (TCO) layer 102. Preferably, the first nanocrystalline or microcrystalline p-type layer 3a is chosen with a specific architectural crystallographic lattice structure having a significantly lower electrical resistivity than an equivalent p-type layer 103 silicon based with an amorphous crystallographic structure together with very good optical properties.

In order to positively deposit the first nanocrystalline or microcrystalline p-type layer 3a during 303a the process parameters of the PECVD equipment 600 are advantageously finely controlled, monitored and tuned. Particularly, during the 303a a H₂/SiH₄ ratio low enough to minimize the incubation time due to H₂ induced ZnO surface modification is advantageously defined. In this manner it is possible to avoid the formation of low density nucleation micro or nano-crystallites and high enough to have fully coalesced micro or nano-crystalline phase without the presence of amorphous phases within. Preferred values of SiH₄/(SiH₄ + H₂) or H₂/SiH₄ are around 0.5% and B₂H₆/(SiH₄ + B₂H₆) around 8%.

In some embodiments a second amorphous p-type layer 3b comprises silicon (Si), silicon and hydrogen (Si-H) or the like. Preferably, the deposition rate used during 303a for depositing the first nanocrystalline or microcrystalline p-type layer 3a with a designed dopant concentration are sufficiently high to lessen H₂ induced accumulation layer which increases the depletion zone: this process feature is ruled by the SiH₄ flow set at 0,36 slm and the Plasma generator device power set at 0,1 W/cm². In some embodiments where the dopant is a boron compound, precursor comprising trimethylboron (B(CH₃)₃ or TMB), diborane (BH₃)₂, borontrifluoride (BF₃), triethylboron (B(C₂H₅)₃ or TEB) or the like are advantageously used. To achieve an adequate doping of the first nanocrystalline or microcrystalline p-type layer 3a with a designed dopant concentration B₂H₆ or TMB flows must be controlled in the range of 0 to 100 sccm with the SiH₄ flow is constructively set at 5 slm and H₂ at 100 slm. To achieve the adequate doping of the thin micro or nano interface layer the B₂H₆ or TMB flow must be controlled in the range of 0 to 100 sccm when SiH₄ is varied from 0 to 5 slm and H₂ from 0 to 100 slm. Other type of dopants such as arsenic could be used to actively dope the p-type layer though the use of boron turns out to be more viable when associated with the PECVD techniques.

According to a preferred embodiment, an optimal range for boron doping concentration in the first nanocrystalline or microcrystalline p-type layer 3a is between 1E19 and 5E20 at/cm³. As an example when B₂H₆ is utilized the B₂H₆/SiH₄ ratio in the range between 1E-2 and 1E-4 must be used for optimal performances with the desired crystallographic structures.

Preferably, the thickness of the first nanocrystalline or microcrystalline p-type layer 3a is formed with a first dopant concentration. Preferably, the range of thickness of the first nanocrystalline or microcrystalline p-type layer 3a produced according to 303a is between 3 and 10 nm with a deposition time lower than 30 sec (giving a deposition growth rate of about 6 nm/min to 20 nm/min). This allows a good trade-off between light transmission and electrical performances. Above those thicknesses light absorption by the nano-crystalline layer will have a significant impact on Tandem cell Current density (Jsc) and on the series resistance of the monolithically connected cells, below such values the work function alignment improvement will be lost. According to a preferred embodiment, an optimal thickness value of the first nanocrystalline or microcrystalline p-type layer 3a is around 7nm. It is important to underline that above these thickness values light absorption by the first nanocrystalline or microcrystalline p-type layer 3a decreases with the reduction of the tandem cell current density (Jsc) and with the increase of the series resistance of the solar cell apparatus 100, while below these thickness values the work function alignment improvement between the first nanocrystalline or microcrystalline p-type layer 3a silicon based and the n-type transparent conductive oxide (TCO) layer 102 silicon based is mainly lost. Preferably, the deposition temperatures at the 303a are in the range of almost 150 and 190 °C.

Next, at 303b of the method 400, a second amorphous p-type layer 3b with a second dopant concentration is deposited over the first nanocrystalline or microcrystalline p-type layer 3a as shown in details in Fig. 2.

Preferably, the first nanocrystalline or microcrystalline p-type layer 3a represents an interface structure interposed between the TCO and the second amorphous p-type layer 3b.

The second amorphous p-type layer 3b comprises any material suitable to produce the necessary features to form the p-i-n structure 200. In some embodiments the second amorphous p-type layer 3b comprises silicon (Si), silicon carbide (SiC) or the like. Furthermore dopants concentration within the second amorphous p-type layer 3b is varied with respect to the one of the first nanocrystalline or microcrystalline p-type layer 3a. Preferably, when boron (B) is used as dopant, suitable values of SiH₄/(SiH₄ + H₂) or H₂/SiH₄ are around 5% and B₂H₆/(SiH₄ + B₂H₆) around 6% . According to an embodiment, the second amorphous p-type layer 3b shows a dopants concentration gradient as a function of its thickness.

In embodiments where the dopant is a boron compound advantageously are used precursor comprising trimethylboron (B(CH₃)₃ or TMB), diborane (BH₃)₂, borontrifluoride (BF₃), triethylboron (B(C₂H₅)₃ or TEB) or the like. To achieve an adequate doping of the second amorphous p-type layer 3b with a designed dopant concentration B₂H₆ flows is preferably controlled in the range of 2-10 %.

In particular an advantageous range for boron doping concentration in the second amorphous p-type layer 3b is between 5 and 8 %. As an example, when B₂H₆ is used as the precursor gas 30 - 60 sccm generates the desired crystallographic structures.

In some embodiments the second amorphous p-type layer 3b has a thickness in the range of 3-10 nm, with an advantageous thickness of almost 6 nm, having a deposition rate similar to the one used to produce the first nanocrystalline or microcrystalline p-type layer 3a (i.e. between 6 nm/min and 20 nm/min). Crystallites dimensions in the second amorphous p-type layer 3b result significantly reduced with respect to those contained in the first nanocrystalline or microcrystalline p-type layer 3a as a consequence of a SiH₄/(SiH₄ +H₂) flow increase within the PECVD reactor.

Typical deposition temperatures at the step 303b are in the range of 160 and 200°C. Next at step 303c of the method 400, a third amorphous p-type layer 3c with a third dopant concentration is deposited over the second amorphous p-type layer 3b as shown in details in figure 2.

According to a preferred embodiment, the third amorphous p-type layer 3c comprises any material suitable to produce the necessary features to form the p-i-n structure 200. In some embodiments the third amorphous p-type layer 3c comprises silicon (Si), silicon carbide (SiC) or the like. Furthermore, dopants concentration within the third amorphous p-type layer 3c is varied with respect to the one of the second amorphous p-type layer 3b. Preferably, when boron (B) is used as dopant, suitable values of SiH₄/(SiH₄ + H₂) are around 9% and B₂H₆/(SiH₄ + B₂H₆ ) around 4.8%.

In embodiments where the dopant is a boron compound advantageously are used precursor comprising trimethylboron (B(CH₃)₃ or TMB), diborane (BH₃)₂, borontrifluoride (BF₃), triethylboron (B(C₂H₅)₃ or TEB) or the like. To achieve an adequate doping of the third amorphous p-type layer 3c with a designed dopant concentration B₂H₆ or TMB flows is preferably controlled in the range of 30-60 seem. In particular an optimal range for boron doping concentration in the third amorphous p-type layer 3c is between 3% and 7%. As an example, when B₂H₆ is used as the precursor gas with 50 sccm flow generates the desired crystallographic structures.

In some embodiments the third amorphous p-type layer 3c has a thickness comprised between almost 5 to 10 nm with a lower deposition rate than the one set to deposit the second p-type amorphous layer 3b comprised between almost 2 nm/min and 10 nm/min.

Preferably, crystallites dimensions in the third amorphous p-type layer 3c result significantly reduced with respect to those contained in the second amorphous p-type layer 3b due to SiH₄/(SiH₄ + H₂) flow increase within the PECVD reactor.

That is to say that, preferably, the third amorphous p-type layer 3c comprises a smaller average crystallites dimension than said fourth amorphous p-type layer 3d and said fourth amorphous p-type layer 3d comprises a smaller average crystallites dimension than said second amorphous p-type layer 3b.

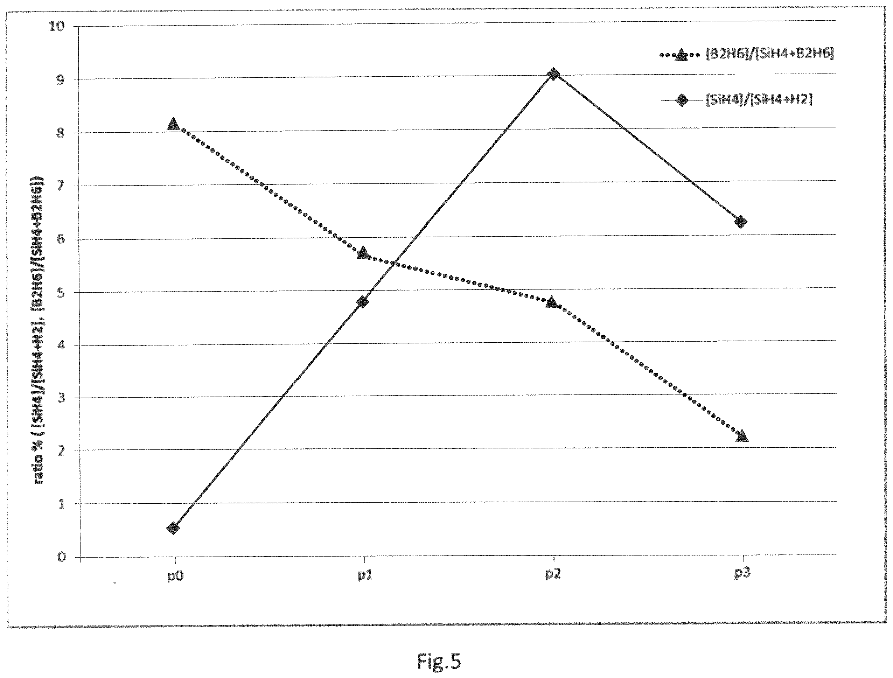

With reference to Fig.5 it is therefore apparent that, being the crystallographic structure generally inversely proportional to the [SiH₄]/[(SiH₄ + H₂)] ratio due to its amorphisation effect, the crystallites structures trend of the first, second, third and fourth p-type layer show a relative minimum at the third amorphous p-type layer 3c resulting in a not purely monotone slope.

With reference to fig. 5 the labels p0, p1, p2, p3 refer respectively to the first nanocrystalline or microcrystalline p-type layer 3a, the second amorphous p-type layer 3b, the third amorphous p-type layer 3c, the fourth amorphous p-type layer 3d. At p0 the SiH4 concentration is kept low in the range of 0.5% to 2% during the growth of the first thin nano-crystalline layer deposited on TCO. Then it is increased to typical values of amorphous phase in the range of 4% to 10% for p1 and p2 deposition. At the same time (at p1, p2 and p3) CH4 is introduced to keep higher band gap window. Dopants (as reported on fig 2 by mean of B2H6 or TMB concentration) are tapered as well to achieve smooth potential drops when moving from p0 to p3.

Doping profile of p0, p1 and p2 layers is obtained with a proper ramp of the dopant flow concentration (B2H6 or TMB ) respect total flow in the range of 0.01% to 1%. The use of a "graded" multilayer structure is fundamental because it helps reducing the mechanical stress at the interface. This is the only way to avoid the occurrence of serious delamination when the substrate (TCO) has peaked texture features, necessary to induce high light scattering (high haze). The higher the texture shapes the more important the effect of the graded multilayer for reducing delamination occurrence.

In addition the fact that the dopants are tapered allows to reduce the potential barrier height at the interface allowing the low lifetime photo-generated holes to be efficiently collected at the electrode.

Preferably, to achieve the adequate doping of the thin micro or nano interface layer the B2H6 or TMB flow must be controlled in the range of 0 to 100 sccm when SiH4 is varied from 0 to 5 slm and H2 from 0 to 100 slm.

The optimal range for boron doping concentration in the p-layer is between 1E19 and 5E20 at/cm3. As an example when B2H6 is utilized the B2H6/SiH4 ratio in the range between 1E-2 and 1E-4 must be used for optimal performances. Other type of dopants such as arsenic could be used to actively dope the p-type layer though the use of boron turns out to be more viable when associated with the PECVD techniques.

The thickness of the nanocrystalline layer is fundamental and must be optimized to reduce the light adsorption in said thin layer.

According to an embodiment, 3 to 10 nm is the typical range to have the good trade-off between light transmission and electrical performances. The optimal value that we have found for a tandem a-Si:H/uc-Si:H junction with a ZnO front TCO is of ~7nm. Above those thicknesses light absorption by the nano-crystalline layer will have a significant impact on Tandem cell Current density (Jsc) and on the series resistance of the monolithically connected cells, below such values the work function alignment improvement will be lost.

Therefore, the following layer thickness sequence is preferably used: ZnO TCO + p type Si nano crystalline interface layer of 7 nm + p-type a-SiC:H of 15 nm + intrinsic a-Si:H of 200 to 300nm + n-type a-Si:H or n type - a-SiC:H of 10 to 20 nm + other conventional layers used in the state of the art manufacturing of thin film silicon single junction or multiple junction solar cells.

Preferred deposition temperatures at 303c are in the range of almost 180 and 200°C. Next at 303d of the method 400, a fourth amorphous p-type layer 3d with a fourth dopant concentration is deposited over the third amorphous p-type layer 3c as shown in details in figure 2.

The fourth amorphous p-type layer 3d comprises any material suitable to produce the necessary features to form the p-i-n structure 200. In some embodiments the fourth amorphous p-type layer 3d comprises silicon (Si), silicon carbide (SiC) or the like. According to a preferred embodiment, dopants concentration within the fourth amorphous p-type layer 3d is varied with respect to the one of the third amorphous p-type layer 3c. Preferably, when boron (B) is used as dopant, suitable values of SiH₄/(SiH₄ + H₂) or H₂/SiH₄ are around 6.0% and B₂H₆/(SiH₄ + B₂H₆ ) around 2.0%. In some embodiments where the dopant is a boron compound advantageously are used precursor comprising trimethylboron (B(CH₃)₃ or TMB), diborane (BH₃)₂, borontrifluoride (BF₃), triethylboron (B(C₂H₅)₃ or TEB) or the like. To achieve an adequate doping of the fourth amorphous p-type layer 3d with a designed dopant concentration B₂H₆ or TMB flows are preferably controlled in the range of 10-30 sccm. According to a preferred embodiment, an optimal range for boron doping concentration in the fourth amorphous p-type layer 3d is between 1E19 and 5E20 at/cm³. As an example when B₂H₆ is used as the precursor gas with a flow of about 20 sccm generates the desired crystallographic structures. In some embodiments the fourth amorphous p-type layer 3d has a thickness comprised between almost 2 to 10 nm. Preferably, the deposition rate is higher than the one set to deposit the third p-type amorphous layer 3c. Even more preferably, the deposition rate is comprised between almost 1nm/min and 6nm/min. According to a preferred embodiment, crystallites dimensions in the fourth amorphous p-type layer 3d result increased with respect to those contained in the third amorphous p-type layer 3c due to SiH₄/(SiH₄ + H₂) flow reduction within the PECVD reactor. Preferred deposition temperatures at 303c are in the range of almost 180-200 C.

According to the present invention, when boron (B) is chosen as dopant its concentration varies from the highest value in the first nanocrystalline or microcrystalline p-type layer 3a to the lowest value in the fourth p-type amorphous layer 3d denoting a tapering boron concentration profile.

Next at 404 of the method 400, the i-type layer 104 comprised in the p-i-n structure 200 (realized according to step 500) is deposited over the fourth amorphous p-type layer 3d as shown in Fig. 1 and 2. Preferably, the i-type layer 104 comprises an amorphous phase and, according to a preferred embodiment, exhibits a thickness comprised between 200 and 300 nm. In some embodiments, the i-type layer 104 comprises silicon (Si), silicon carbide (SiC), silicon and hydrogen (Si-H) or the like. SiH₄/(SiH₄ +H₂) concentration is preferably 6,3% and SiH₄/H₂ ratio is preferably 15 to ensure the proper nanostructure of the intrinsic amorphous layer.

Next at step 405 of the method 400, the n-type layer 105 comprised in the p-i-n structure 200 (realized at 500) is deposited over the i-type layer 104 as shown in Fig. 1 and 2.

Preferably, the n-type layer 105 comprises an amorphous phase and, according to a preferred embodiment, exhibits a thickness comprised between 10 and 20 nm. In some embodiments the n-type layer 105 comprises silicon (Si), silicon carbide (SiC), silicon and hydrogen (Si-H) or the like. The SiH₄/(SiH₄ + H₂) ratio is 10% for the bulk deposition and is decreased to 0,7% at the interface with the micro-crystalline n-p junction.

According to a preferred embodiment, the n-type layer 105 comprises dopants suitable to enhance charge collection and thus increasing the efficiency of the solar cell apparatus 100. Examples of suitable dopants are any element of Group V such as phosphorous (P), arsenic (As), antimony (Sb) or like.

Next at 405 a metal back layer 106 is deposited over the n-type layer 105 comprised in the p-i-n structure 200 as shown in figure 1 and 2. According to a preferred embodiment, the metal back layer 106 comprises any suitable material such as zinc oxide (ZnO), aluminum (Al), titanium (Ti), gold (Au), copper (Cu), silver (Ag), platinum (Pt), chromium (Cr), alloys thereof, combination thereof, or the like. Preferably, the metal back layer 106 has a suitable thickness to positively collaborate within the solar cell apparatus 100 in order to maintain the desired photovoltaic characteristics of the device. Preferably, the metal back layer 106 has a thickness comprised between 50 and 200 nm.

Preferably, the metal back layer 106 is formed by any suitable deposition technic such as CVD or PVD or the like in accordance with the teachings described: for example in some embodiments the metal back layer 106 is formed by PECVD or, in some others, by magnetron sputtering.

After the deposition of the metal back layer 106, the method 400 generally terminates and the solar cell apparatus 100 is suitable to be further processed by any desired technic aimed at finishing or completing the solar cell apparatus 100.

The invention thus remedies the problem posed and at the same time offers a plurality of advantages, including obtaining a lower work-function TCO, with better optical transmittance and controllable haze.

Furthermore, the apparatus and the method of the present invention increase the open circuit voltage (Voc) and hence improve the contact resistance between a transparent conducting oxide (TCO) and a p-doped silicon based layer of a p-i-n structure comprised in said solar cell apparatus.

With an adequately designed p-type dopants graded multi-layers structure it is possible to significantly increase the Voc due to a reduced work function mismatch and reduction of the depletion layer of at the TCO/p-SiC interface.

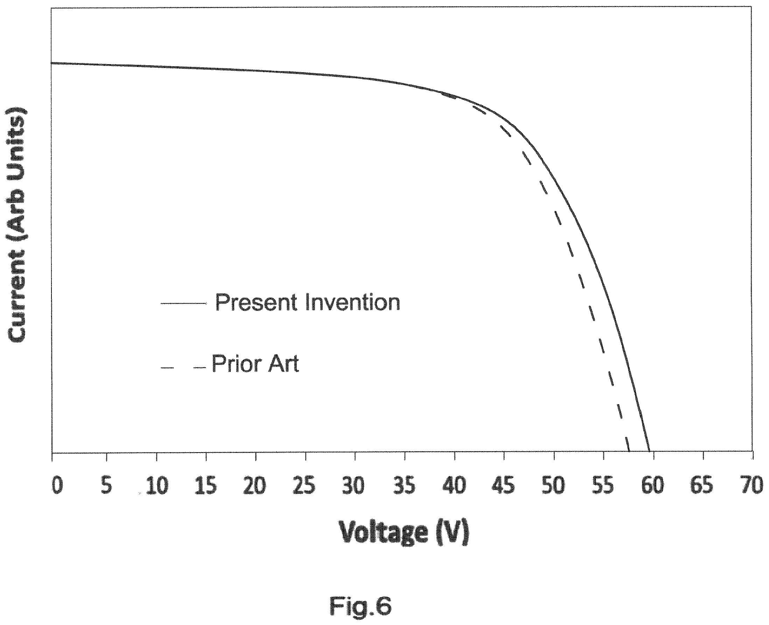

A comparison between a solar cell apparatus according to present invention and the relevant prior art is represented in Fig. 6 showing the I-V curves under AM1.5G illumination at 1 sun for two modules with a tandem solar cell configuration and a ZnO:B front TCO of about 1300nm with haze of 20% at 550nm. The former module has no interface layer between a ZnO based TCO layer and a p-type a-Si, the latter has the p-type dopants graded multi-layers structure of the present invention.

It will be appreciated that the use of the proposed p-type dopants graded multi-layers structure improves the I-V of the cell with ZnO:B front contact. The Voc is significantly increased, of more than 2% (corresponding to ~1.5V in our large area module). In addition, due to the improvement of the contact resistance the fill factor is improved. The interface improvement has certainly raised the maximum power output of the module with ZnO:B front contact of more than 5W.

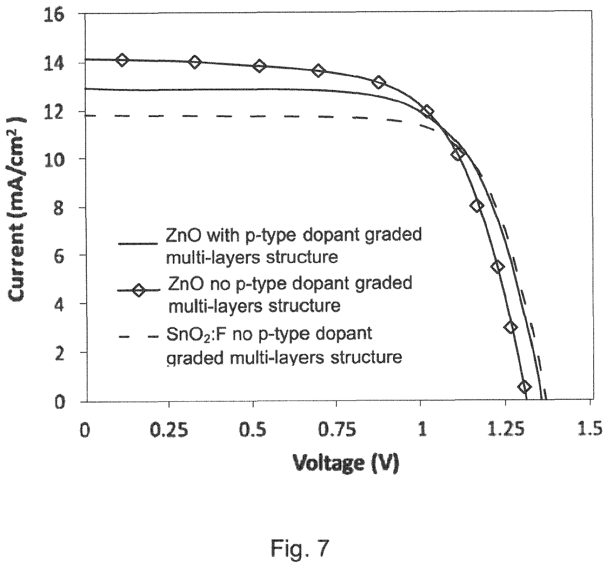

Furthermore, by analyzing the intrinsic properties on small area cells as shown in Fig. 7, it is possible to observe that the proposed nanocrystalline interfacial layer can significantly improve the Voc and the FF of the solar cell. Nevertheless, the insertion of the small gap nanocrystalline thin layer can slightly reduce the Jsc current due to some absorption in the doped thin layer. However the higher FF and Voc lead to a clear advantage with respect to the case of ZnO not provided with a p-type dopants graded multi-layers structure. Fig. 7 also shows that the insertion of the p-type dopants graded multi-layers structure leads to Voc and FF values similar to those of solar cells with SnO2:F TCO that have a more favorable work function value than ZnO, and usually exhibit less rectifying effects and hence better contact resistance.

## Claims

1. A solar cell apparatus (100) comprising:
• a substrate (101);
• an n-type transparent conductive oxide (TCO) layer (102) being zinc oxide deposited over said substrate (101);
• a p-i-n structure (200), deposited on the n-type transparent conductive oxide (TCO) layer (102), including
∘ a p-type layer (103)
∘ an i-type layer (104)
∘ said n-type layer (105)
• a metal back layer (106) deposited over said n-type layer (105) of said p-i-n structure (200); wherein
• said p-type layer (103) comprises a p-type dopants graded multi-layers structure (3) having a dopants concentration profile that varies as a function of thickness of said p-type dopants graded multi-layers structure (3), wherein
• said p-type dopants graded multi-layers structure (3) comprises boron (B) as a doping element,
• said p-type dopants graded multi-layers structure (3) comprises:
∘ a first nanocrystalline or microcrystalline p-type layer (3a),
∘ a second amorphous p-type layer (3b),
∘ a third amorphous p-type layer (3c),
∘ a fourth amorphous p-type layer (3d),
∘ said second, third and fourth amorphous p-type layers (3b, 3c, 3d) having different dopant concentrations and the boron (B) dopant concentration varies from the highest value in the first nanocrystalline or microcrystalline p-type layer (3a) to the lowest value in the fourth p-type amorphous layer (3d) denoting a tapering boron concentration profile.

2. A solar cell apparatus (100) according to claim 1, wherein said third amorphous p-type layer (3c) comprises a smaller average crystallites dimension than said fourth amorphous p-type layer (3d) and said fourth amorphous p-type layer (3d) comprises a smaller average crystallites dimension than said second amorphous p-type layer (3b).

3. A solar cell apparatus (100) according to any claims from 1 to 2, wherein said first nanocrystalline or microcrystalline p-type layer (3a) comprises silicon (Si) or silicon carbide (SiC)

4. A solar cell apparatus (100) according to any of claims 1 to 3, wherein said second amorphous p-type layer (3b), said third amorphous p-type layer (3c) and said fourth amorphous p-type layer (3d) comprise silicon (Si) or silicon carbide (SiC) or silicon and hydrogen (Si-H).

5. A method (400) for forming of a solar cell apparatus (100) comprising:
• depositing an n-type transparent conductive oxide (TCO) (102), being zinc oxide, on a substrate via plasma enhanced chemical vapor deposition (PECVD);
• forming a p-i-n structure (200) including:
∘ depositing a p-type layer (103) over said n-type transparent conductive oxide (TCO) (102) via plasma enhanced chemical vapor deposition (PECVD);
∘ depositing an i-type layer (104) over said p-type layer (103) via plasma enhanced chemical vapor deposition (PECVD);
∘ depositing an n-type layer (105) over said i-type layer (104) via plasma enhanced chemical vapor deposition (PECVD);
wherein depositing said p-type layer (103) comprised in said p-i-n structure (200) includes
• forming a p-type dopants graded multi-layers structure (3), comprising boron as a doping element, via plasma enhanced chemical vapor deposition (PECVD), comprising:
∘ depositing a first nanocrystalline or microcrystalline p-type layer (003a) with a first dopants concentration over said n-type transparent conductive oxide (TCO) (102) via plasma enhanced chemical vapor deposition (PECVD);
∘ depositing a second amorphous p-type layer (3b) with a second dopants concentration over said first nanocrystalline or microcrystalline p-type layer (3a) via plasma enhanced chemical vapor deposition (PECVD),
• depositing a third amorphous p-type layer (3c) with a third dopants concentration over said second amorphous p-type layer (3b) via plasma enhanced chemical vapor deposition (PECVD);
• depositing a fourth amorphous p-type layer (3d) with a fourth dopants concentration over said third amorphous p-type layer (3c) via plasma enhanced chemical vapor deposition (PECVD),
• wherein said fourth dopant concentration is smaller than said third dopant concentration, which is smaller than said second dopant concentration which is smaller than said first dopant concentration.

6. A method according to claim 5, wherein said third amorphous p-type layer (3c) is deposited achieving a smaller average crystallites dimension than said fourth amorphous p-type layer (3d) and said fourth amorphous p-type layer (3d) is deposited achieving a smaller average crystallites dimension than said second amorphous p-type layer (3b).

7. A method according to claim 6, wherein said p-type dopants graded multilayers structure (3) is formed varying SiH₄/(SiH₄ + H₂) ratio fluxes.

8. A method according to claim 7 wherein said first nanocrystalline or microcrystalline p-type layer (3a) comprised in said p-type dopants graded multilayers structure (3) is formed having a SiH₄/(SiH₄ + H₂) ratio fluxes set at a value lower than that one used to produce said second amorphous p-type layer (3b), said second amorphous p-type layer (3b) is formed having a SiH₄/(SiH₄ + H₂) ratio fluxes set at a value lower than that one used to produce said third amorphous p-type layer (3c) and said third amorphous p-type layer (3c) is formed having a SiH₄/(SiH₄ + H₂) ratio fluxes set at a value higher than that one used to produce said a fourth amorphous p-type layer (3d).

9. A method according to any of claims 5 to 8 further comprising depositing a metal back layer (106) over said p-i-n structure (200).

## Patentansprüche

1. Solarzellenvorrichtung (100), umfassend:
• ein Substrat (101);
• eine transparente leitfähige Oxid- (TCO) Schicht (102) vom n-Typ aus Zinkoxid, die auf dem Substrat (101) abgeschieden ist;
• eine p-i-n-Struktur (200), die auf der transparenten leitfähigen Oxid- (TCO) Schicht (102) vom n-Typ abgeschieden ist, umfassend
∘ eine p-Typ-Schicht (103)
∘ eine i-Typ-Schicht (104)
∘ die n-Typ-Schicht (105)
• eine Metall-Rückseitenschicht (106), die auf der n-Typ-Schicht (105) der p-i-n-Struktur (200) abgeschieden ist; wobei
• die p-Typ-Schicht (103) eine mit p-Typ-Dotierstoffen abgestufte Mehrschichtstruktur (3) mit einem Dotierstoffkonzentrationsprofil umfasst, das als Funktion der Dicke der mit p-Typ-Dotierstoffen abgestuften Mehrschichtstruktur (3) variiert, wobei
• die mit p-Typ-Dotierstoffen abgestufte Mehrschichtstruktur (3) Bor (B) als Dotierelement umfasst,
• die mit p-Typ-Dotierstoffen abgestufte Mehrschichtstruktur (3) umfasst:
∘ eine erste nanokristalline oder mikrokristalline p-Typ-Schicht (3a),
∘ eine zweite amorphe p-Typ-Schicht (3b),
∘ eine dritte amorphe p-Typ-Schicht (3c),
∘ eine vierte amorphe p-Typ-Schicht (3d),
∘ wobei die zweiten, dritten und vierten amorphen p-Typ-Schichten (3b, 3c, 3d) unterschiedliche Dotierstoffkonzentrationen aufweisen und die Bor-(B) Dotierstoffkonzentration vom höchsten Wert in der ersten nanokristallinen oder mikrokristallinen p-Typ-Schicht (3a) bis zum niedrigsten Wert in der vierten amorphen p-Typ-Schicht (3d) variiert, was ein sich verjüngendes Bor-Konzentrationsprofil kennzeichnet.

2. Solarzellenvorrichtung (100) nach Anspruch 1, wobei die dritte amorphe p-Typ-Schicht (3c) eine kleinere durchschnittliche Kristallitgröße als die vierte amorphe p-Typ-Schicht (3d) aufweist, und die vierte amorphe p-Typ-Schicht (3d) eine kleinere durchschnittliche Kristallitgröße als die zweite amorphe p-Typ-Schicht (3b) aufweist.

3. Solarzellenvorrichtung (100) nach einem der Ansprüche 1 bis 2, wobei die erste nanokristalline oder mikrokristalline p-Typ-Schicht (3a) Silizium (Si) oder Siliziumkarbid (SiC) umfasst.

4. Solarzellenvorrichtung (100) nach einem der Ansprüche 1 bis 3, wobei die zweite amorphe p-Typ-Schicht (3b), die dritte amorphe p-Typ-Schicht (3c) und die vierte amorphe p-Typ-Schicht (3d) Silizium (Si) oder Siliziumkarbid (SiC) oder Silizium und Wasserstoff (Si-H) umfassen.

5. Verfahren (400) zum Bilden einer Solarzellenvorrichtung (100), das folgende Schritte umfasst:
• Abscheiden eines transparenten leitfähigen Oxids (TCO) (102) vom n-Typ aus Zinkoxid auf einem Substrat mittels plasmaunterstützter chemischer Gasphasenabscheidung (PECVD);
• Bilden einer p-i-n-Struktur (200) umfassend:
∘ Abscheiden einer p-Typ-Schicht (103) auf dem transparenten leitfähigen Oxid (TCO) (102) vom n-Typ mittels plasmaunterstützter chemischer Gasphasenabscheidung (PECVD);
∘ Abscheiden einer i-Typ-Schicht (104) auf der p-Typ-Schicht (103) mittels plasmaunterstützter chemischer Gasphasenabscheidung (PECVD);
∘ Abscheiden einer n-Typ-Schicht (105) auf der i-Typ-Schicht (104) mittels plasmaunterstützter chemischer Gasphasenabscheidung (PECVD);
wobei das Abscheiden der in der p-i-n-Struktur (200) enthaltenen p-Typ Schicht (103) umfasst:
• Bilden einer mit p-Typ-Dotierstoffen abgestuften Mehrschichtstruktur (3), die Bor als Dotierelement umfasst, mittels plasmaunterstützter chemischer Gasphasenabscheidung (PECVD), umfassend:
∘ Abscheiden einer ersten nanokristallinen oder mikrokristallinen p-Typ-Schicht (003a) mit einer ersten Dotierstoffkonzentration auf dem transparenten leitfähigen Oxid (TCO) (102) vom n-Typ mittels plasmaunterstützter chemischer Gasphasenabscheidung (PECVD);
∘ Abscheiden einer zweiten amorphen p-Typ-Schicht (3b) mit einer zweiten Dotierstoffkonzentration auf der ersten nanokristallinen oder mikrokristallinen p-Typ-Schicht (3a) mittels plasmaunterstützter chemischer Gasphasenabscheidung (PECVD);
• Abscheiden einer dritten amorphen p-Typ-Schicht (3c) mit einer dritten Dotierstoffkonzentration auf der zweiten amorphen p-Typ-Schicht (3b) mittels plasmaunterstützter chemischer Gasphasenabscheidung (PECVD);
• Abscheiden einer vierten amorphen p-Typ-Schicht (3d) mit einer vierten Dotierstoffkonzentration auf der dritten amorphen p-Typ-Schicht (3c) mittels plasmaunterstützter chemischer Gasphasenabscheidung (PECVD),
• wobei die vierte Dotierstoffkonzentration kleiner als die dritte Dotierstoffkonzentration ist, die kleiner als die zweite Dotierstoffkonzentration ist, die kleiner als die erste Dotierstoffkonzentration ist.

6. Verfahren nach Anspruch 5, wobei die dritte amorphe p-Typ-Schicht (3c) unter Erreichung einer kleineren durchschnittlichen Kristallitgröße als die vierte amorphe p-Typ-Schicht (3d) abgeschieden wird, und die vierte amorphe p-Typ-Schicht (3d) unter Erreichung einer kleineren durchschnittlichen Kristallitgröße als die zweite amorphe p-Typ-Schicht (3b) abgeschieden wird.

7. Verfahren nach Anspruch 6, wobei die mit p-Typ-Dotierstoffen abgestufte Mehrschichtstruktur (3) mit einem variierenden SiH4/(SiH4 + H2) - Flussmittelverhältnis gebildet wird.

8. Verfahren nach Anspruch 7, wobei die erste nanokristalline oder mikrokristalline p-Typ-Schicht (3a), die in der mit p-Typ-Dotierstoffen abgestuften Mehrschichtstruktur (3) enthalten ist, mit einem SiH4/(SiH4 + H2)-Flussgrößenverhältnis gebildet wird, das auf einen niedrigeren Wert als den eingestellt ist, der zur Herstellung der zweiten amorphen p-Typ-Schicht (3b) verwendet wird, die zweite amorphe p-Typ-Schicht (3b) mit einem SiH4/(SiH4 + H2)-Flussgrößenverhältnis gebildet wird, das auf einen niedrigeren Wert als den eingestellt ist, der zur Herstellung der dritten amorphen p-Typ-Schicht (3c) verwendet wird, und die dritte amorphe p-Typ-Schicht (3c) mit einem SiH4/(SiH4 + H2)-Flussmittelverhältnis gebildet wird, das auf einen höheren Wert als den eingestellt ist, der zur Herstellung einer vierten amorphen p-Typ-Schicht (3d) verwendet wird.

9. Verfahren nach einem der Ansprüche 5 bis 8, das ferner das Abscheiden einer Metall-Rückseitenschicht (106) auf der p-i-n-Struktur (200) umfasst.

## Revendications

1. Appareil à cellule solaire (100) comprenant :
• un substrat (101) ;
• une couche d'oxyde conducteur transparent (TCO) de type n (102) étant de l'oxyde de zinc déposé sur ledit substrat (101) ;
• une structure p-i-n (200), déposée sur la couche d'oxyde conducteur transparent (TCO) de type n (102), comportant
∘ une couche de type p (103)
∘ une couche de type i (104)
∘ ladite couche de type n (105)
• une couche arrière métallique (106) déposée sur ladite couche de type n (105) de ladite structure p-i-n (200) ; dans lequel
• ladite couche de type p (103) comprend une structure multicouche à gradient de dopants de type p (3) ayant un profil de concentration de dopants qui varie en fonction de l'épaisseur de ladite structure multicouche à gradient de dopants de type p (3), dans lequel
• ladite structure multicouche à gradient de dopants de type p (3) comprend du bore (B) en tant qu'élément dopant,
• ladite structure multicouche à gradient de dopants de type p (3) comprend :
∘ une première couche de type p nanocristalline ou microcristalline (3a),
∘ une deuxième couche de type p amorphe (3b),
∘ une troisième couche de type p amorphe (3c),
∘ une quatrième couche de type p amorphe (3d),
∘ lesdites deuxième, troisième et quatrième couches de type p amorphes (3b, 3c, 3d) ayant différentes concentrations de dopant et la concentration de dopant de bore (B) varie de la valeur la plus élevée dans la première couche de type p nanocristalline ou microcristalline (3a) à la valeur la plus basse dans la quatrième couche amorphe de type p (3d) indiquant un profil effilé de concentration de bore.

2. Appareil à cellule solaire (100) selon la revendication 1, dans lequel ladite troisième couche de type p amorphe (3c) comprend une dimension moyenne des cristallites inférieure à ladite quatrième couche de type p amorphe (3d) et ladite quatrième couche de type p amorphe (3d) comprend une dimension moyenne des cristallites inférieure à ladite deuxième couche de type p amorphe (3b).

3. Appareil à cellule solaire (100) selon l'une quelconque des revendications 1 à 2, dans lequel ladite première couche de type p nanocristalline ou microcristalline (3a) comprend du silicium (Si) ou du carbure de silicium (SiC).

4. Appareil à cellule solaire (100) selon l'une quelconque des revendications 1 à 3, dans lequel ladite deuxième couche de type p amorphe (3b), ladite troisième couche de type p amorphe (3c) et ladite quatrième couche de type p amorphe (3d) comprennent du silicium (Si) ou du carbure de silicium (SiC) ou du silicium et de l'hydrogène (Si-H).

5. Procédé (400) de formation d'un appareil à cellule solaire (100) comprenant :
• le dépôt d'un oxyde conducteur transparent (TCO) de type n (102), étant de l'oxyde de zinc, sur un substrat par l'intermédiaire d'un dépôt chimique en phase vapeur assisté par plasma (PECVD) ;
• la formation d'une structure p-i-n (200) comportant :
∘ le dépôt d'une couche de type p (103) sur ledit oxyde conducteur transparent (TCO) de type n (102) par l'intermédiaire d'un dépôt chimique en phase vapeur assisté par plasma (PECVD) ;
∘ le dépôt d'une couche de type i (104) sur ladite couche de type p (103) par l'intermédiaire d'un dépôt chimique en phase vapeur assisté par plasma (PECVD) ;
∘ le dépôt d'une couche de type n (105) sur ladite couche de type i (104) par l'intermédiaire d'un dépôt chimique en phase vapeur assisté par plasma (PECVD) ;
dans lequel le dépôt de ladite couche de type p (103) comprise dans ladite structure p-i-n (200) comporte
• la formation d'une structure multicouche à gradient de dopants de type p (3) comprenant du bore en tant qu'élément dopant, par l'intermédiaire d'un dépôt chimique en phase vapeur assisté par plasma (PECVD), comprenant :
∘ le dépôt d'une première couche de type p nanocristalline ou microcristalline (003a) ayant une première concentration de dopants sur ledit oxyde conducteur transparent (TCO) de type n (102) par l'intermédiaire d'un dépôt chimique en phase vapeur assisté par plasma (PECVD) ;
∘ le dépôt d'une deuxième couche de type p amorphe (3b) ayant une deuxième concentration de dopants sur ladite première couche de type p nanocristalline ou microcristalline (3a) par l'intermédiaire d'un dépôt chimique en phase vapeur assisté par plasma (PECVD),
• le dépôt d'une troisième couche de type p amorphe (3c) ayant une troisième concentration de dopants sur ladite deuxième couche de type p amorphe (3b) par l'intermédiaire d'un dépôt chimique en phase vapeur assisté par plasma (PECVD) ;
• le dépôt d'une quatrième couche de type p amorphe (3d) ayant une quatrième concentration de dopants sur ladite troisième couche de type p amorphe (3c) par l'intermédiaire d'un dépôt chimique en phase vapeur assisté par plasma (PECVD),
• dans lequel ladite quatrième concentration de dopants est inférieure à ladite troisième concentration de dopants, qui est inférieure à ladite deuxième concentration de dopants qui est inférieure à ladite première concentration de dopants.

6. Procédé selon la revendication 5, dans lequel ladite troisième couche de type p amorphe (3c) est déposée pour obtenir une dimension moyenne des cristallites inférieure à ladite quatrième couche de type p amorphe (3d) et ladite quatrième couche de type p amorphe (3d) est déposée pour obtenir une dimension moyenne des cristallites inférieure à ladite deuxième couche de type p amorphe (3b).

7. Procédé selon la revendication 6, dans lequel ladite structure multicouche à gradient de dopants de type p (3) est formée en faisant varier les flux de rapport SiH₄/(SiH₄ + H₂).

8. Procédé selon la revendication 7, dans lequel ladite première couche de type p nanocristalline ou microcristalline (3a) comprise dans ladite structure multicouche à gradient de dopants de type p (3) est formée ayant un flux de rapport SiH₄/(SiH₄ + H₂) fixé à une valeur inférieure à celle utilisée pour produire ladite deuxième couche de type p amorphe (3b), ladite deuxième couche de type p amorphe (3b) est formée ayant un flux de rapport SiH₄/(SiH₄ + H₂) fixé à une valeur inférieure à celle utilisée pour produire ladite troisième couche de type p amorphe (3c) et ladite troisième couche de type p amorphe (3c) est formée ayant un flux de rapport SiH₄/(SiH₄ + H₂) fixé à une valeur supérieure à celle utilisée pour produire ladite une quatrième couche de type p amorphe (3d).

9. Procédé selon l'une quelconque des revendications 5 à 8, comprenant en outre le dépôt d'une couche arrière métallique (106) sur ladite structure p-i-n (200).
